# EUROPÄISCHE PATENTANMELDUNG

(11) **EP 1 233 279 A2**
(43) Veröffentlichungstag der Anmeldung: **21.08.2002**
(21) Anmeldenummer: 02100150.8
(22) Anmeldetag: 19.02.2002
(51) Int. Cl.: G01R 33/36, G01R 33/38

(54) **Magnetresonanz-Bildgerät mit offenem Magnetsystem**

(30) Priorität: 20.02.2001 DE 10107867
(71) Anmelder: Philips Corporate Intellectual Property GmbH, 52066 Aachen (DE); Koninklijke Philips Electronics N.V., 5621 BA Eindhoven (NL)
(72) Erfinder: Leussler, Christoph, Philips Corp.Int.Prop. GmbH, 52066, Aachen (DE)
(74) Vertreter: Volmer, Georg, Dipl.-Ing.

(57) **Zusammenfassung**

Es wird ein Magnetresonanz-Bildgerät (MR-Bildgerät) mit einem offenen Magnetsystem beschrieben, bei dem ein ein Untersuchungsobjekt senkrecht durchsetzendes Grundmagnetfeld (Vertikalfeld) und ein Hochfrequenzfeld erzeugt wird, und das sich insbesondere dadurch auszeichnet, dass Kopplungseffekte zwischen einer durch das Magnetsystem (10) gebildeten Dipolstruktur (11, 12, 13) und einer HF-Leiterstruktur (20, 21, 22) entweder durch Verschiebung bzw. Verstimmung einer Eigenresonanzfrequenz der Dipolstruktur gegenüber der MR-Frequenz oder durch Unterdrückung einer Eigenresonanzfrequenz der Dipolstruktur zumindest weitgehend beseitigt sind.

## Beschreibung

Die Erfindung betrifft ein Magnetresonanz-Bildgerät (MR-Bildgerät) mit einem offenen Magnetsystem. Diese Magnetsysteme sind im wesentlichen C-förmig und haben einen oberen und einen unteren, jeweils horizontalen Abschnitt, die durch eine vertikale Säule miteinander verbunden sind. Ein Untersuchungsobjekt (Patient) wird zwischen die horizontalen Abschnitte eingebracht. Da das Untersuchungsobjekt von allen Seiten gut zugänglich ist, werden diese Systeme (im Gegensatz zu solchen mit rohrförmigem Untersuchungsraum) als offene Magnetsysteme bezeichnet, wobei auch eine oder mehrere weitere vertikale Säulen vorgesehen sein können, um zum Beispiel die mechanische Stabilität des Magnetsystems zu erhöhen.

An den horizontalen Abschnitten dieser Magnetsysteme befinden sich Polplatten zur Erzeugung eines Grundmagnetfeldes (B₀-Feld) sowie von Gradient-Magnetfeldern. Das Grundmagnetfeld tritt im wesentlichen in einer Richtung senkrecht zur Längsachse des Patienten (d h. im allgemeinen vertikal) durch diesen hindurch.

Zur Erzeugung eines Hochfrequenzfeldes (B₁-Feld) sowie zur Erfassung von MR-Relaxationsvorgängen werden flache oder zumindest flächenartige HF-Leiterstrukturen ("Flächenresonatoren") in Form von HF-Sende-bzw. HF-Empfangsspulen verwendet, die jeweils an den Polplatten angeordnet sind. Weiterhin können HF-Empfangsspulen auch um einen zu untersuchenden Bereich gelegt werden.

Die MR-Frequenz ist abhängig von der Stärke des Grundmagnetfeldes. Bei den heute üblichen Feldstärken von etwa 0,2 Tesla ergibt sich eine MR-Frequenz von etwa 8,2 MHz. Zur Verbesserung der Bildqualität wird allgemein angestrebt, diese Feldstärke in einen Bereich von bis zu etwa 1 Tesla zu erhöhen, wofür sich eine MR-Frequenz von etwa 42,3 MHz ergeben würde. Diese Frequenz würde jedoch zahlreiche Schwierigkeiten beim Betrieb eines MR-Bildgerätes bekannter Art verursachen.

Ein erstes Problem ergibt sich daraus, dass das Magnetsystem selbst einen elektrischen Resonator darstellt, da die C-Form die Wirkung eines gefalteten Dipols hat. Die Eigenresonanzfrequenz eines supraleitenden C-förmigen Magnetsystems liegt bei den üblichen Abmessungen eines MR-Gerätes, das zur Untersuchung von Menschen vorgesehen ist, im Bereich von 40 bis 50 MHz und somit in der gleichen Grössenordnung wie die MR-Frequenz bei einer Feldstärke des Grundmagnetfeldes von 1 Tesla (42,3 MHz). Dies hat zur Folge, dass elektromagnetische Energie von einer entsprechenden HF-Sendespule in das Magnetsystem abfließen und dort Resonanzen anregen kann, die zu hohen elektrischen und magnetischen Feldern am Mantel des Magneten und insbesondere an den freien Enden der C-Form ("Hot Spots") führen können. Weiterhin können die HF-Empfangsspulen mit dem Magnetsystem koppeln, so dass sich das Signal /Rauschverhältnis verschlechtert und die Bilderzeugung beeinträchtigt wird.

Erschwerend kommt noch hinzu, dass die HF-Sendespulen im allgemeinen unmittelbar an den Polplatten angeordnet sind, wo sich ein Strommaximum der durch das Magnetsystem gebildeten Dipolstruktur befindet, so dass die HF-Sendespulen besonders empfindlich auf die resonante Dipolstruktur reagieren und sich auch dadurch eine relativ starke Ankopplung und Beeinflussung der HF-Sendespulen ergibt. Dies kann sogar zur Folge haben, dass mit Quadraturspulenanordnungen, die in dem Magnetsystem vorhanden sind, kein zirkular polarisiertes HF-Feld mehr erzeugt werden kann, weil durch die Kopplung mit dem Dipolfeld die Orthogonalität aufgehoben wird.

Ein weiteres Problem besteht darin, dass im Gegensatz zu den Bildgeräten mit einem rohrförmigen Untersuchungsraum die HF-Leiterstrukturen bei offenen MR-Systemen elektromagnetische Energie im wesentlichen frei in den umgebenden Raum abstrahlen. Der Raum, in dem ein MR-Bildgerät aufgestellt ist, muss deshalb stets abgeschirmt sein, um eine Störung der Umgebung durch die elektromagnetische Energie zu verhindern. Ein solcher Raum (HF-Käfig) stellt jedoch gleichzeitig einen Hohlraumresonator dar, der Energie absorbieren kann. Der Grundmode eines solchen Raums mit den typischen Abmessungen von 5 mal 5 mal 3 Metern liegt bei etwa 42 MHz, so dass Raumresonanzen angeregt werden können und Kopplungen zwischen den auf die (im wesentlichen gleiche) MR-Frequenz abgestimmten HF-Leiterstrukturen und dem Raum unvermeidlich sind Eine Erhöhung der Feldstärke des Grundmagnetfeldes würde also bei den bekannten MR-Bildgeräten zahlreiche Probleme verursachen.

Eine Aufgabe, die der Erfindung zugrunde liegt, besteht deshalb darin, ein MR-Bildgerät der eingangs genannten Art zu schaffen, das mit wesentlich höheren Feldstärken (d.h. von bis zu 1 Tesla oder mehr) des Grundmagnetfeldes im wesentlichen störungsfrei und mit hoher Bildqualität betrieben werden kann.

Eine Lösung dieser Aufgabe erfolgt gemäss Anspruch 1 mit einem Magnetresonanz-Bildgerät mit offenem Magnetsystem, das sich dadurch auszeichnet, dass Kopplungseffekte zwischen einer durch das Magnetsystem gebildeten Dipolstruktur und einer auf eine MR-Frequenz abgestimmten HF-Leiterstruktur durch Verschiebung bzw. Verstimmung einer Eigenresonanzfrequenz der Dipolstruktur gegenüber der MR-Frequenz zumindest weitgehend beseitigt sind.

Bei einer weiteren Lösung sind gemäss Anspruch 2 diese Kopplungseffekte durch Unterdrückung einer Eigenresonanzfrequenz der Dipolstruktur zumindest weitgehend beseitigt.

Im Bedarfsfall lassen sich diese beiden Maßnahmen auch miteinander kombinieren.

Die Unteransprüche haben vorteilhafte Weitetbildungen der Erfindung zum Inhalt.

In den Ansprüchen 3 bis 6 werden vorteilhafte Arten der Verschiebung bzw. Verstimmung der Eigenresonanzfrequenz der Dipolstruktur durch Veränderung von deren elektrischer Länge beschrieben.

Die Ansprüche 7 bis 10 betreffen die Unterdrückung der Eigenresonanzfrequenz der Dipolstruktur durch eine Mantelwellensperre und ihre vorteilhaften Ausgestaltungen.

Um deren Wirkung im Hinblick auf eine Vermeidung von Kopplungen zwischen dem Magnetsystem und der HF-Leiterstruktur zu optimieren, wird die Mantelwellensperre gemäss Anspruch 8 vorzugsweise auf die MR-Frequenz abgestimmt.
Die Ausführungen gemäss den Ansprüchen 9 und 10 sind insbesondere dann vorteilhaft, wenn sich die geometrische Länge der Mantelwellensperre von der tatsächlich erforderlichen elektrischen Länge unterscheidet.

Mit der Ausführung gemäss Anspruch 11 wird sowohl eine Störung der Umgebung außerhalb eines HF-Käfigs durch abgestrahlte elektromagnetische Energie, als auch die Ausbildung von stehenden Wellen innerhalb des HF-Käfigs weitgehend verhindert.

Weitere Einzelheiten, Merkmale und Vorteile der Erfindung ergeben sich aus der folgenden Beschreibung von bevorzugten Ausführungsformen anhand der Zeichnung.

Es zeigt:
Fig. 1 eine schematische dreidimensionale Darstellung eines MR-Bildgerätes in einem Untersuchungsraum;
Fig. 2 eine Seitenansicht einer ersten Ausführungsform des Magnetsystems;
Fig. 3 eine Seitenansicht einer zweiten Ausführungsform des Magnetsystems;
Fig. 4 eine vergrößerte Darstellung eines Teils des Magnetsystems;
Fig. 5 eine Seitenansicht einer dritten Ausführungsform des Magnetsystems;
Fig. 6 eine schematische Draufsicht auf eine vierte Ausführungsform des Magnetsystems; und
Fig. 7 eine schematische Darstellung eines Untersuchungsraums mit einem MR-Bildgerät von oben.

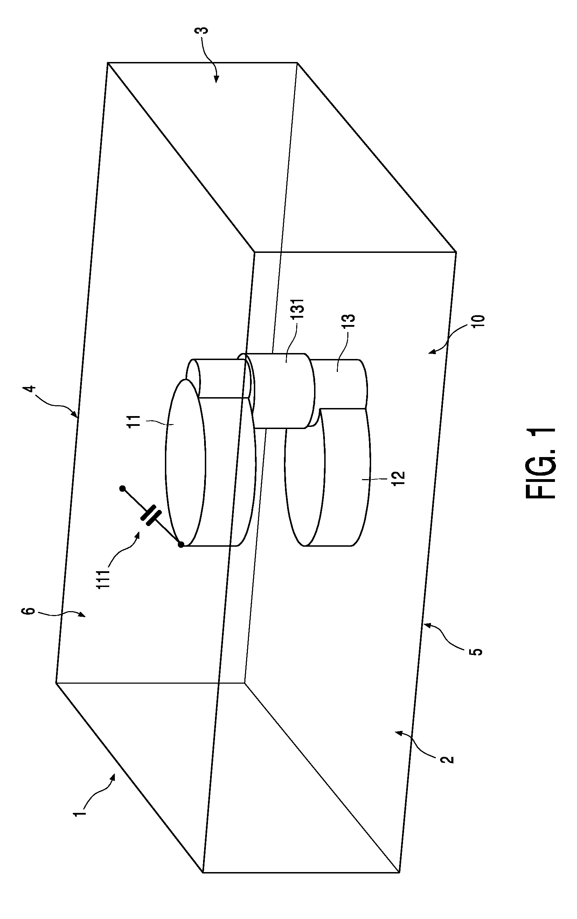

Figur 1 zeigt einen Raum mit vier Seitenwänden 1 bis 4, einem Boden 5 und einer Decke 6. Aus den eingangs genannten Gründen ist der Raum allseitig abgeschirmt und bildet einen HF-Käfig, so dass durch die innerhalb des Raums erzeugte elektromagnetische Energie außerhalb des Raums keine Störungen verursacht werden können.

In dem Raum befindet sich ein MR-Bildgerät, von dem nur das Magnetsystem 10 dargestellt ist. Das Magnetsystem hat eine C-Form, die einen oberen horizontalen Abschnitt 11, einen unteren horizontalen Abschnitt 12 sowie eine diese verbindende vertikale Säule 13 umfasst. Der obere und der untere Abschnitt 11, 12, zwischen denen sich der Untersuchungsbereich für einen Patienten befindet, beinhaltet Magnete zur Erzeugung eines vertikalen Grundmagnetfeldes mit einer Feldstärke von bis zu etwa 1 Tesla, sowie von Gradient-Magnetfeldern in üblicher Weise.

Der obere Abschnitt 11 ist an seinem der Säule 13 gegenüberliegenden freien Ende über eine im wesentlichen kapazitive Impedanz 111 an die Abschirmung an der Decke 6 des Raums HF-gekoppelt, während der untere Abschnitt 12 auf dem Boden 5 des Raums steht. Der untere Abschnitt muss dabei nicht unbedingt gegenüber dem Boden isoliert sein, da das Magnetsystem über verschiedene Anschlüsse wie z. B. Versorgungsleitungen für die Gradientspulen usw. in jedem Fall auf Massepotential liegt.

Wie eingangs bereits erläutert wurde, hat das C-förmige Magnetsystem 10 die elektrischen Eigenschaften einer gefalteten Dipolstruktur. Durch die Verbindung des oberen Abschnitts 11 mit dem HF-Käfig wird der Dipol elektrisch verlängert, so dass sich seine Resonanzfrequenz entsprechend vermindert und von der MR-Frequenz, die bei einer Feldstärke des Grundmagnetfeldes von etwa 1 Tesla bei etwa 42,3 MHz liegt, beabstandet wird. Dadurch werden gleichzeitig Kopplungseffekte zwischen dem Magnetsystem und den HF-Leiterstrukturen vermindert oder beseitigt.

Gegebenenfalls kann zur Verbindung anstelle der kapazitiven Impedanz auch eine Kurzschluss-Verbindung gewählt werden.

Weiterhin befindet sich an der Säule 13 des Magnetsystems 10 eine Mantelwellensperre (Impedanz-Trap, Bazooka Balun) 131 in Form eines zusätzlichen elektrisch leitfähigen Schirms, der hübenähnlich um die Säule 13 gelegt ist und eine elektrische Länge von λ/4 aufweist (die wirksame elektrische Länge kann durch den Einsatz von Kondensatoren und/oder Dielektrika an eine abweichende geometrische Länge angepasst werden). Ein vertikales Ende des Schirms ist dabei mit der inneren Magnetstruktur kurzgeschlossen, während das andere Ende offen ist. Dadurch wirkt die Mantelwellensperre wie eine offene λ/4-Leitung und stellt somit für hochfrequente Ströme der Wellenlänge λ eine hochohmige Sperre dar, so dass die elektrische Resonanz der Dipolstruktur bei der Wellenlänge λ, die vorzugsweise die MR-Frequenz ist, unterdrückt wird.
In Abhängigkeit von der Stärke des Grundmagnetfeldes sowie dem Grad der sich dadurch ergebenden Annäherung zwischen der MR-Frequenz und der durch die Abmessungen des Magnetsystems gegebenen Eigenresonanzfrequenz der Dipolstruktur können eine oder beide der oben genannten Maßnahmen gewählt werden, um eine ausreichende Entkopplung zwischen den HF-Leiterstrukturen und dem Magnetsystem zu erzielen. Darüber hinaus kann auch der untere Abschnitt 12 des Magnetsystems 10 kapazitiv an die im Boden 5 befindliche Abschirmung angekoppelt werden, um die Länge des Dipols weiter zu vergrößern.

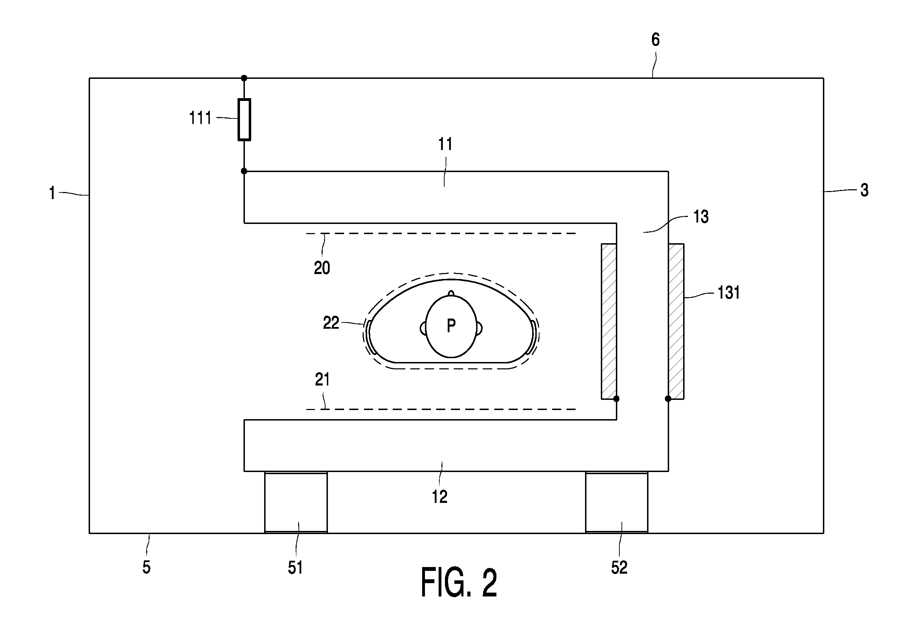

Figur 2 zeigt die erste Ausführungsform in Seitenansicht. Gleiche Teile wie in Figur 1 sind mit gleichen Bezugsziffern bezeichnet. Das Magnetsystem steht, vorzugsweise elektrisch isoliert, auf Füssen 51, 52 und umfasst den horizontalen oberen Abschnitt 11, den horizontalen unteren Abschnitt 12 und die diese verbindende vertikale Säule 13. Die Mantelwellensperre 131 ist aufgeschnitten dargestellt und an ihrem unteren Ende mit der Magnetstruktur der Säule 13 verbunden, während ihr oberes Ende offen ist. Das freie Ende des oberen Abschnitts 11 ist über die im wesentlichen kapazitive Impedanz 111 (oder eine Kurzschluss-Verbindung) an die Abschirmung an der Decke 6 des Raums gekoppelt. Weiterhin sind die HF-Leiterstrukturen dargestellt, die in diesem Fall durch eine erste HF-Sendespule 20 unter dem oberen Abschnitt 11, eine zweite HF-Sendespule 21 über dem unteren Abschnitt 12 sowie eine HF-Empfangsspule 22 gebildet sind, wobei die HF-Empfangsspule 22 um einen Patienten P gelegt ist.

Wenn die erste und die zweite HF-Sendespule 20, 21 durch ein gemeinsames Speisekabel miteinander verbunden sind, kann durch diese Elemente eine zweite Dipolstruktur entstehen, auf der sich eine weitere Dipolresonanz ausbildet. Um diese Resonanz zu unterdrücken, wird das gemeinsame Speisekabel ebenfalls mit einer Mantelwellensperre umgeben. Alternativ dazu ist es auch möglich, das Speisekabel durch die die Säule 13 umgebende Mantelwellensperre 131 zu führen, so dass diese sowohl auf der Magnetstruktur 11, 12, 13, als auch auf den HF-Sendespulen 20, 21 Resonanzen verhindert.

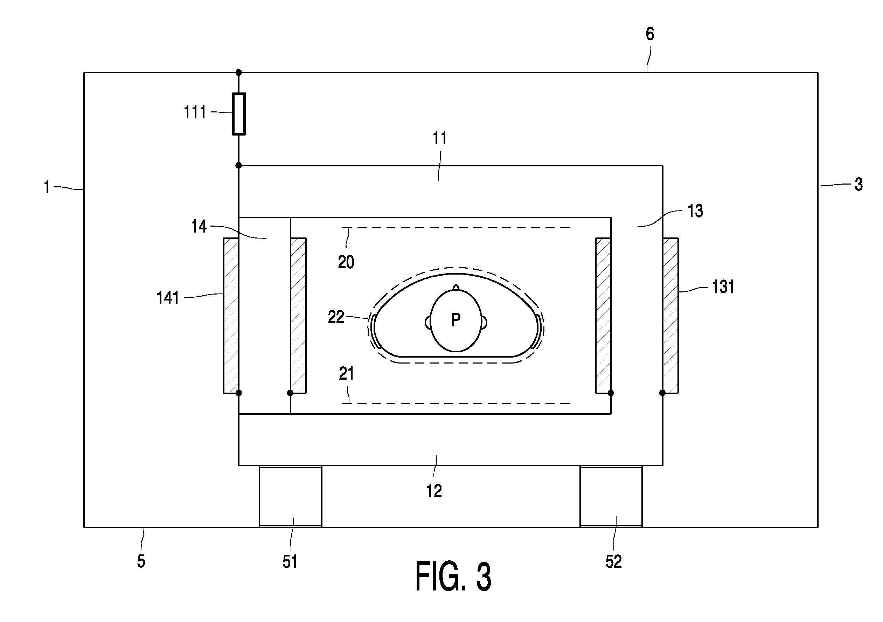

Figur 3 zeigt eine zweite Ausführungsform der Erfindung, bei der die in den Figuren 1 und 2 freien Enden des oberen und unteren Abschnitts 11, 12 des Magnetsystems mit einer zweiten Säule 14 abgestützt sind Da die Zugänglichkeit des Patienten P dadurch kaum beeinträchtigt wird, werden auch diese und andere Systeme mit drei oder vier Säulen als offene Systeme bezeichnet.

Auch die zweite Säule 14 ist von einer Mantelwellensperre 141 (aufgeschnitten dargestellt) mit einer Länge von λ/4 umgeben, deren eines Ende mit der Magnetstruktur kurzgeschlossen ist und deren anderes Ende offen ist, so dass wiederum eine λ/4-Leitung entsteht, die für hochfrequente Ströme eine hochohmige Sperre darstellt und dadurch elektrische Resonanzen des Magnetsystems bei der Wellenlänge λ (MR-Frequenz) unterdrückt. Darüber hinaus sind gleiche Teile wie in Figur 2 wieder mit gleichen Bezugsziffern bezeichnet, so dass auf eine erneute Beschreibung verzichtet werden kann.

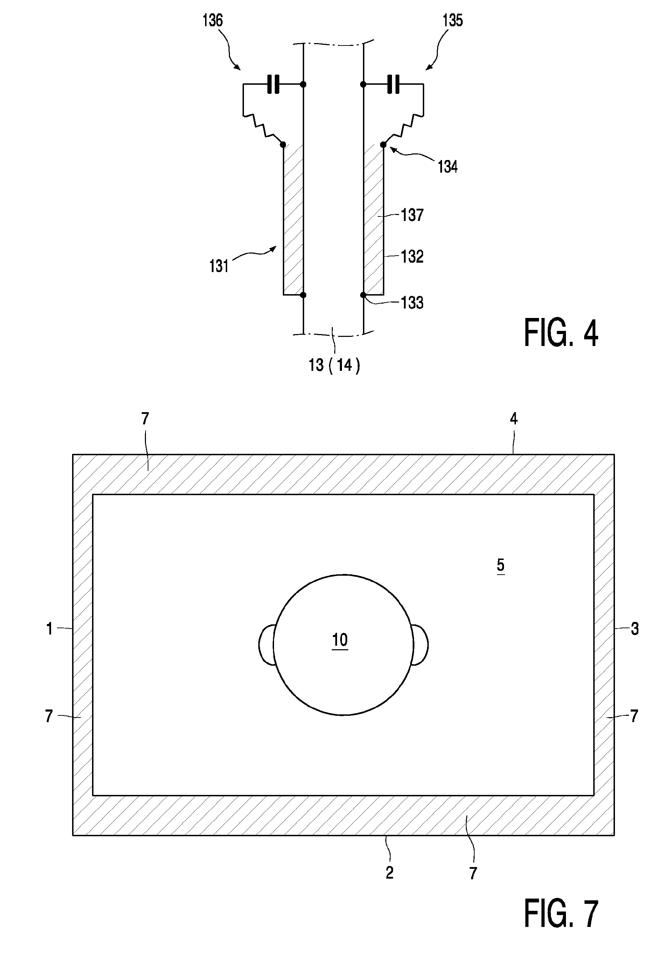

Figur 4 zeigt im Detail einen Teil der Säulen 13 (14) mit der Mantelwellensperre 131 (141) im Querschnitt. Die Mantelwellensperre ist durch einen im wesentlichen hülsenförmigen, elektrisch leitfähigen Schirm 132 (Hülse) gebildet, der die Säule 13 koaxial umgibt, so dass zwischen beiden ein Zwischenraum mit einer Breite von etwa 1 bis 2 cm vorhanden ist. Der Schirm ist an seinem unteren Ende 133 mit der Magnetstruktur der Säule elektrisch verbunden. Das obere Ende 134 des Schirms 132 ist frei oder über einen oder mehrere, vorzugsweise einstellbare Kondensatoren 135, 136 an die Magnetstruktur gekoppelt. Weiterhin befindet sich in dem Zwischenraum zwischen dem Schirm 132 und der Säule 13 ein Dielektrikum 137 (zum Beispiel ein keramisches Material). Das Dielektrikum sowie die Kondensatoren dienen zum Einstellen der elektrisch wirksamen Länge der Mantelwellensperre in der Weise, dass sich eine auf die MR-Frequenz abgestimmte λ/4-Leitung ergibt. Auf diese Weise ist eine Unterdrückung von Resonanzen im Bereich der MR-Frequenz mit etwa 10 bis 30 dB und somit eine entsprechende Entkopplung zwischen dem Magnetsystem 10 und der HF-Leiterstruktur 20, 21, 22 zu erzielen.

Der Schirm 132 umschließt nach Art einer Hülse die Säule 13 koaxial und hat im wesentlichen die gleiche Querschnittsform wie diese. Der Schirm und die Säule können somit einen kreisförmigen, viereckigen oder anderen Querschnitt aufweisen.

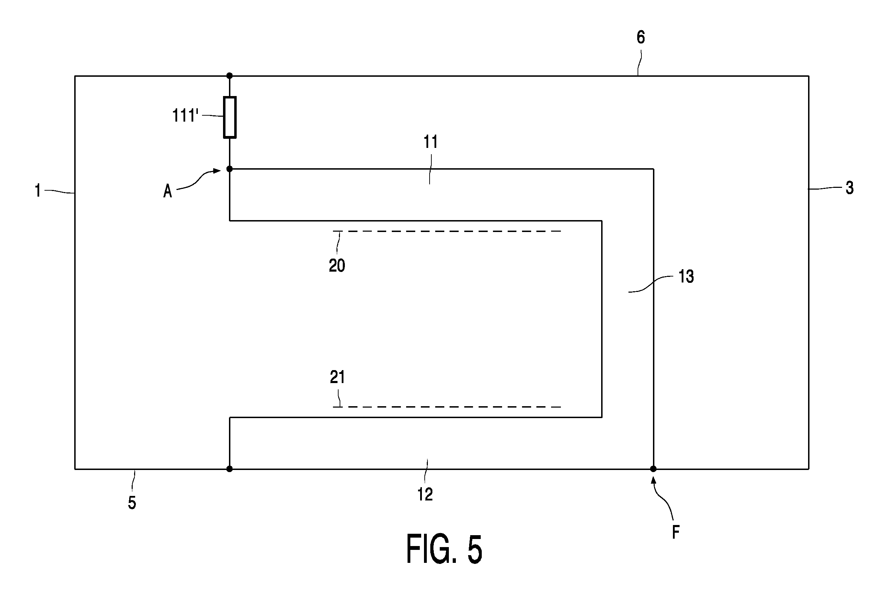

Figur 5 zeigt eine dritte Ausführungsform der Erfindung, bei der der untere Abschnitt 12 des Magnetsystems in elektrischer Verbindung mit der an dem Boden 5 des Raums vorhandenen Abschirmung steht. In diesem Fall muss die Ausbildung von sogenannten Ground-Plane-Resonanzen verhindert werden, da ein Ende des Dipols mit Massepotential verbunden ist. Zu diesem Zweck ist das Magnetsystem 10 so bemessen, dass sich zwischen dem Fußpunkt F der Säule 13 und dem Punkt A der Ankopplung einer Impedanz 111' an den oberen Abschnitt 11 eine Leitungslänge von n*λ/4 ergibt. Diese Leitungslänge bewirkt zusammen mit der in Serie geschalteten und mit der Abschirmung an der Decke 6 verbundenen kapazitiven Impedanz 111' eine Verschiebung der Resonanzfrequenz des Dipols aus dem Bereich der MR-Frequenz, so dass Kopplungseffekte zwischen den HF-Leiterstrukturen und dem Magnetsystem zumindest vermindert werden. Zur Abstimmung ist die kapazitive Impedanz 111' wiederum vorzugsweise einstellbar. Gegebenenfalls ist es auch möglich, auf die Impedanz zu verzichten und den Punkt A direkt an die Abschirmung in der Decke 6 zu koppeln (Kurzschluss-Verbindung).

Sofern mit dieser Konfiguration eine ausreichende Entkopplung nicht erzielbar ist, kann eine Kombination mit den anhand der Figuren 2 bis 4 beschriebenen Maßnahmen vorgenommen werden.

Eine weitere Möglichkeit zur Verschiebung der Dipol-Eigenresonanz des Magnetsystems besteht schließlich darin, die oberen und unteren Abschnitte 11, 12 über eine vorzugsweise einstellbare Kapazität miteinander zu verbinden (nicht dargestellt). Dies bietet sich insbesondere bei der in Figur 3 gezeigten zweiten Ausführungsform an, wenn diese Kapazität in die zweite Säule 14 eingebracht wird und sich das Magnetsystem in dem oberen und unteren Abschnitt 11,12 sowie der ersten Säule 13 befindet.

Auch diese Maßnahme kann mit einer oder mehreren der anhand der Figuren 2 bis 4 beschriebenen Maßnahmen kombiniert werden.

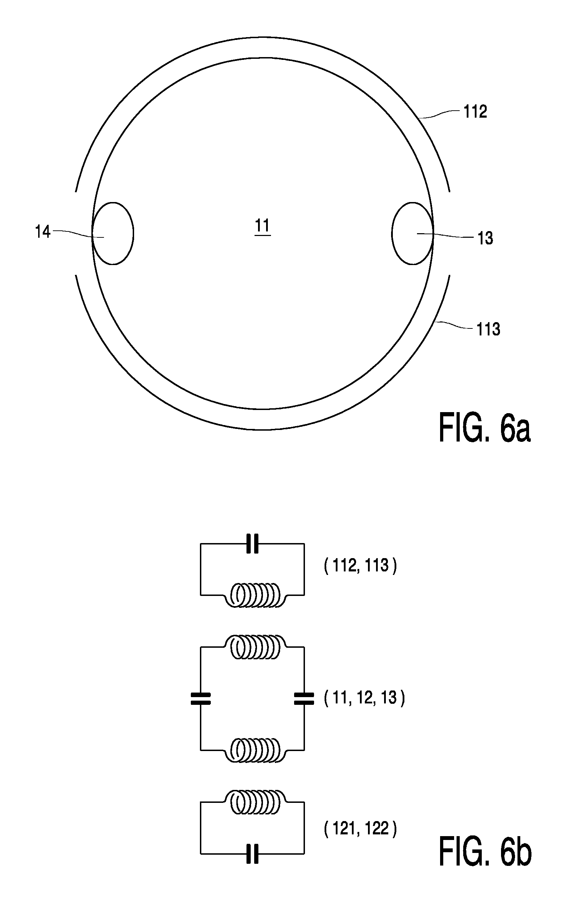

Figur 6(a) zeigt schematisch eine vierte Ausführungsform, der Erfindung in Draufsicht. In dieser Figur ist der obere Abschnitt 11 sowie die erste und zweite Säule 13,14 des Magnetsystems dargestellt. Der obere Abschnitt 11 ist mit einer ersten und einer zweiten, den Abschnitt an seinen Umfangs jeweils halbkreisförmig umgebenden ersten bzw. zweiten Leiterschleife 112, 113 versehen, die induktiv mit dem in dem oberen Abschnitt vorhandenen Teil des Magnetsystems gekoppelt sind. In gleicher Weise ist ferner eine dritte und eine vierte Leiterschleife (nicht dargestellt) halbkreisförmig um den unteren Abschnitt 12 gelegt und mit dem dort vorhandenen Teil des Magnetsystems induktiv gekoppelt.

Das elektrische Ersatzschaltbild dieser Konfiguration ist in Figur 6(b) dargestellt, wobei die zugeordneten Komponenten durch ihre Bezugsziffern angegeben sind. Die erste und zweite Leiterschleife 112, 113 bilden einen ersten Resonanzkreis, während die dritte und vierte Leiterschleife 121, 122 an dem unteren Abschnitt 12 einen zweiten Resonanzkreis darstellen. Zwischen diesen Resonanzkreisen liegt das Magnetsystem mit dem oberen und dem unteren Abschnitt 11, 12 sowie der Säule 13, das einen dritten Resonanzkreis bildet. Die drei Resonanzkreise sind induktiv miteinander gekoppelt.

Die Wirkungsweise dieser Konfiguration beruht darauf, dass durch die Kopplung die Resonanzfrequenz des durch die drei Resonanzkreise gebildeten Gesamtsystems gegenüber der Resonanzfrequenz der durch das Magnetsystem gebildeten Dipolstruktur in der Weise verschoben wird, dass ein ausreichender Abstand zu der MR-Frequenz erzielt und somit eine Kopplung zwischen den HF-Leiterstrukturen und dem Magnetsystem vermieden wird. Alternativ zu den induktiven Leiterschleifen könnte auch eine Kopplung durch kapazitive Elemente vorgenommen werden.

Auch diese Ausführungsform kann im Bedarfsfall wiederum mit einzelnen oder mehreren Merkmalen ergänzt werden, die im Zusammenhang mit den Figuren 2 bis 4 bzw. 5 beschrieben wurden.

Neben der Vermeidung einer Kopplung zwischen den HF-Leiterstrukturen und dem Magnetsystem muss auch sichergestellt werden, dass in dem Raum, in dem das MR-Bildgerät aufgestellt ist und der aus den eingangs genannten Gründen als HF-Käfig ausgebildet ist, keine stehenden Wellen angeregt werden, da diese mit der HF-Sendespule koppeln und zu Störungen führen können. Bei den typischen Raumabmessungen von etwa 5 mal 5 mal 3 Metern ergibt sich nämlich für den Grundmode ein Wert von etwa 42 MHz, der somit im Bereich der MR-Frequenz liegt, wenn das Grundmagnetfeld eine Stärke von etwa 1 Tesla aufweist.

Ein weiteres Problem ergibt sich in diesem Zusammenhang daraus, dass die Abstrahlung in den HF-Käfig durch die übrigen, in dem Käfig vorhandenen Gegenstände sowie die Personen, die darin tätig sind, beeinflusst und verändert werden kann.

Zur Vermeidung dieser Probleme wird das Magnetsystem 10 oder das gesamte MR-Bildgerät in einem HF-Käfig gemäss Figur 7 betrieben. Figur 7 zeigt eine Draufsicht auf den HF-Käfig mit Seitenwänden 1 bis 4, einem Boden 5 sowie einer Decke (nicht dargestellt), mit der der Käfig nach oben abgeschlossen wird. Sämtliche Wände, der Boden sowie die Decke sind an ihrer Innenseite mit einem HF-Absorbermaterial 7 beschichtet. Als Absorbermaterial hat sich ein mit einer Kohlesuspension getränkter Schaumstoff als geeignet erwiesen, der die abgestrahlte elektromagnetische Energie im wesentlichen absorbiert. Darüber hinaus können in dem HF-Käfig zusätzlich Stellwände (nicht dargestellt) mit einem solchen Absorbermaterial vorgesehen sein, die je nach Bedarf in dem Käfig frei verschiebbar sind. Mit einem solchen HF-Käfig, der die genannten Raumabmessungen von 5 mal 5 mal 3 Metern haben kann, können stehende Wellen weitgshend vermieden werden.

## Patentansprüche

1. Magnetresonanz-Bildgerät mit offenem Magnetsystem,
**dadurch gekennzeichnet,**
**dass** Kopplungseffekte zwischen einer durch das Magnetsystem (10) gebildeten Dipolstruktur (11, 12, 13) und einer auf eine MR-Frequenz abgestimmten HF-Leiterstruktur (20, 21, 22) durch Verschiebung bzw. Verstimmung einer Eigenresonanzfrequenz der Dipolstruktur gegenüber der MR-Frequenz zumindest weitgehend beseitigt sind.

2. Magnetresonanz-Bildgerät mit offenem Magnetsystem,
**dadurch gekennzeichnet,**
**dass** Kopplungseffekte zwischen einer durch das Magnetsystem (10) gebildeten Dipolstruktur (11, 12, 13) und einer auf eine MR-Frequenz abgestimmten HF-Leiterstruktur (20, 21, 22) durch Unterdrückung einer Eigenresonanzfrequenz der Dipolstruktur zumindest weitgehend beseitigt sind.

3. Magnetresonanz-Bildgerät nach Anspruch 1,
**dadurch gekennzeichnet,**
**dass** ein erstes Ende der Dipolstruktur (11, 12, 13) über eine kapazitive Impedanz (111, 111') an eine auf Massepotential liegende Struktur (5) gekoppelt ist.

4. Magnetresonanz-Bildgerät nach Anspruch 3,
**dadurch gekennzeichnet,**
**dass** ein zweites Ende der Dipolstruktur (11, 12, 13) elektrisch mit einer auf Massepotential liegenden Struktur (5) verbunden ist, wobei die Länge der Dipolstruktur zwischen der kapazitiven Impedanz (111') und der Massestruktur n*λ/4 beträgt.

5. Magnetresonanz-Bildgerät nach Anspruch 1,
**dadurch gekennzeichnet,**
**dass** die Eigenresonanzfrequenz der Dipolstruktur (11,12,13) durch kapazitive und /oder induktive Elemente an zumindest einem Teil der Dipolstruktur verstimmt ist.

6. Magnetresonanz-Bildgerät nach Anspruch 5,
**dadurch gekennzeichnet,**
**dass** die induktiven Elemente durch mindestens eine mit zumindest einem Teil der Dipolstruktur induktiv gekoppelte Leiterschleife (112, 113) gebildet sind.

7. Magnetresonanz-Bildgerät nach Anspruch 2,
**dadurch gekennzeichnet,**
**dass** die Eigenresonanzfrequenz der Dipolstruktur durch eine zumindest einen Teil (13) der Dipolstruktur (11, 12, 13) umgebende Mantelwellensperre (131; 141) unterdrückt ist.

8. Magnetresonanz-Bildgerät nach Anspruch 7,
**dadurch gekennzeichnet,**
**dass** die Mantelwellensperre (131) durch einen einen Teil der Dipolstruktur (13) koaxial umschließenden, hülsenähnlichen Schirm (132) mit einer elektrischen Länge von λ der Magnetresonanz-Wellenlänge λ gebildet ist, wobei ein erstes axiales Ende des Schirms mit der Dipolstruktur elektrisch verbunden und ein zweites Ende offen ist.

9. Magnetresonanz-Bildgerät nach Anspruch 8,
**dadurch gekennzeichnet,**
**dass** zur Erzielung der elektrischen Länge von λ/4 zwischen den Schirm (132) und die Dipolstruktur (13) ein Dielektrikum (137) eingebracht ist.

10. Magnetresonanz-Bildgerät nach Anspruch 8,
**dadurch gekennzeichnet,**
**dass** zur Erzielung und /oder Abstimmung der elektrischen Länge von λ/4 das offene Ende des Schirms (132) über mindestens eine vorzugsweise abstimmbare kapazitive Impedanz (135, 136) an die Dipolstruktur (13) gekoppelt ist.

11. Magnetresonanz-Bildgerät nach Anspruch 1 oder 2,
**dadurch gekennzeichnet,**
**dass** die Massestruktur (5) Teil eines das Magnetsystem (10) umschließenden HF-Käfigs ist, dessen Wände (1 bis 6) mit einem HF-Absorbermaterial (7) beschichtet sind.
